# DEMANDE DE BREVET EUROPEEN

(11) **EP 0 549 403 A1**
(43) Date de publication de la demande: **30.06.1993**
(21) Numéro de dépôt: 92403396.2
(22) Date de dépôt: 14.12.1992
(51) Int. Cl.: F16B 41/00

(54) **Procédé et dispositif pour rendre imperdable une vis de fixation d'un circuit imprimé sur un support**

(30) Priorité: 20.12.1991 FR 9115896
(71) Demandeur: THOMSON-CSF, 75008 Paris (FR)
(72) Inventeur: Moulin, Jacques, F-92402 Courbevoie Cédex (FR)
(74) Mandataire: Lincot, Georges

(57) **Abrégé**

Le procédé consiste à immobiliser la vis (3) entre les parois élastiques (2) d'un boîtier (1) par pincement de la vis entre les parois après avoir percé le fond (8) du boîtier (1) d'un trou (9) pour permettre le serrage de la vis (3) par un outil de serrage, à engager l'extrémité de la vis opposée à sa outil de serrage, à engager l'extrémité de la vis opposée à sa tête dans un trou de fixation du circuit imprimé (4) sur son support (5), et à fixer les extrémités des parois opposées au fond du boîtier sur le circuit imprimé autour du trou de fixation du circuit imprimé (4).

Application : Fabrication de circuits imprimés.

## Description

La présente invention concerne un procédé et un dispositif pour rendre imperdable une vis de fixation d'un circuit imprimé sur un support.

Elle s'applique notamment à la réalisation d'un dispositif le fixation de circuits imprimés dans des coffrets électroniques.

Il existe de nombreux modes de réalisation de vis imperdables montées sur des circuits imprimés. Ainsi suivant un premier mode connu de réalisation de vis imperdable le corps de la vis n'est fileté qu'à une extrémité, le reste du corps étant lisse et d'un diamètre inférieur, la vis étant introduite par un passage fileté réalisé dans le circuit imprimé grâce par exemple à un écrou serti dans l'épaisseur du circuit imprimé. Selon un deuxième mode de réalisation connu une rondelle frein, en matière plastique par exemple, est placée à l'extrémité filetée de la vis pour empêcher son retrait du circuit imprimé et un lamage est prévu dans l'épaisseur du circuit imprimé ou de son support pour loger la rondelle. Enfin suivant un troisième mode de réalisation connu la vis est maintenue prisonnière dans un canon rapporté mécaniquement sur le circuit imprimé.

L'inconvénient majeur de ces solutions est qu'elles nécessitent des opérations particulières d'usinage et de montage dans le cycle de fabrication des circuits imprimés qui sont très consommatrices en temps le mise en oeuvre et corrélativement en coûts de fabrication.

Le but de l'invention est de pallier les inconvénients précités.

A cet effet, l'invention a pour objet un procédé pour rendre imperdable une vis de fixation d'un circuit imprimé sur un support caractérisé en ce qu'il consiste à immobiliser la vis entre les parois élastiques d'un boîtier par pincement de la vis entre les parois après avoir percé le fond du boîtier d'un trou pour permettre l'accès à la vis d'un outil de serrage, à engager l'extrémité de la vis opposée à sa tête dans un trou de fixation du circuit imprimé sur son support, et à fixer les extrémités des parois opposées au fond du boîtier sur le circuit imprimé autour du trou de fixation du circuit imprimé.

L'invention a également pour objet un dispositif pour rendre imperdable une vis de fixation d'un circuit imprimé sur un support.

L'invention a pour principaux avantages qu'elle permet de rendre imperdable des vis de fixation de cartes électroniques pendant leurs montages, leurs démontages et durant leurs manipulations. Durant toutes ces opérations la vis reste prisonnière du boîtier sur le circuit imprimé grâce aux formes et aux dimensions particulières du boîtier qui assure le maintien et le centrage de la vis sur le circuit imprimé dans un faible encombrement et pour un coût de revient réduit.

D'autres caractéristiques et avantages de l'invention apparaîtront ci-après à l'aide de la description qui suit faite en regard des dessins annexés qui représentent :
- Les figures 1 et 2 un premier et un deuxième mode de réalisation d'un dispositif pour rendre imperdable une vis de fixation selon l'invention ;
- Les figures 3A, 3B et 3C des vues respectivement le face, de profil et de dessus d'un troisième mode de réalisation d'un dispositif selon l'invention.

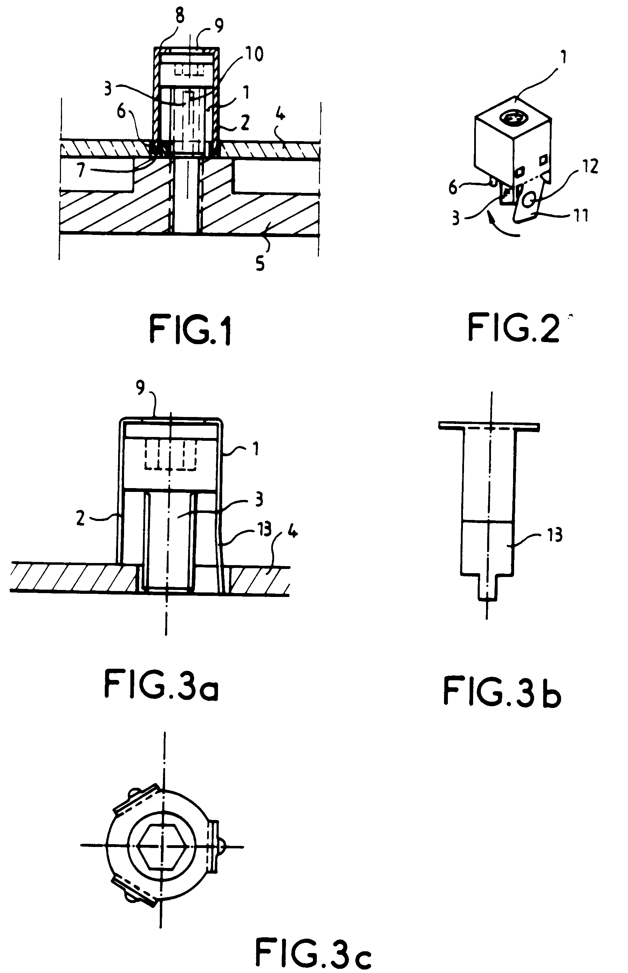

Suivant le mode de réalisation de la figure 1, le dispositif selon l'invention comporte un boîtier embouti 1 dans une feuille métallique légèrement élastique à l'intérieur duquel est maintenue en suspension entre des parois 2 du boîtier 1, entre lesquelles elle est pressée, une vis de serrage 3 d'un circuit imprimé 4 sur un bâtis support 5. De préférence la feuille métallique est traitée en surface par un revêtement étain-plomb par exemple, pour permettre la réalisation d'opérations de brasage à l'étain-plomb sur le circuit imprimé 4. Le boîtier 1 est muni de pattes de fixation 6 permettant la fixation du boîtier 1 par insertion des pattes 6 dans des trous métallisés 7 du circuit imprimé 4 ou par pliage et soudage sur la surface du circuit imprimé sur laquelle s'appuie le boîtier 1. La surface supérieure 8 formant le fond lu boîtier est percée d'un trou 9 dont le diamètre est inférieur au diamètre de la vis afin d'empêcher le passage de celle-ci mais supérieur au diamètre de l'outil de serrage pour serrer la vis. Le boîtier 1 est muni sur ses parois verticales de fentes ou fenêtres 10 qui lui procurent une certaine élasticité. La largeur du boîtier 1 est légèrement inférieure au diamètre de la tête de vis le façon à ce que la vis 3 reste en place par pincement dans le boîtier 1 après y avoir été introduite. Ceci est important lorsque la vis 3 est dévissée car celle-ci reste alors en position haute ce qui facilite le démontage du circuit imprimé 4, sa manipulation et son remontage. La hauteur du corps 1 est égale à la hauteur totale de la vis diminuée de l'épaisseur du circuit imprimé support 4. Ceci permet d'assurer lorsque la vis 3 est totalement relevée que celle-ci ne dépasse pas le circuit imprimé 4 et qu'elle ne puisse pas sortir de son logement.

Dans le mode de réalisation de la figure 2 le boîtier 1 possède une languette 11, formant office de couvercle lorsqu'elle est rabattue pour fermer le boîtier 1 de façon à maintenir la vis 3 à l'intérieur du boîtier 1 lors des manipulations. La languette 11 est percée d'un trou 12 pour laisser voir la vis 3 à l'intérieur du boîtier 1 lorsque la languette 11 est rabattue sur l'ouverture du boîtier 1.

Les pattes de fixation 6 peuvent être dans ce mode de réalisation réparties sur les faces du corps adjacentes à la languette 11. Elles peuvent être du type "à piquer" dans les trous métallisés ou du type court et replié vers l'extérieur pour permettre un montage à la surface du circuit imprimé 4.

Enfin, suivant le mode de réalisation des figures 3A, 3B et 3C où les éléments homologues à ceux des figures 1 et 2 sont représentés avec les mêmes références, le boîtier 1 comporte par exemple, trois parois espacées par des fentes 10, chaque paroi 13 se terminant par une patte de fixation 6 destinée à être introduite dans un trou métallisé du circuit imprimé 4, ce qui permet un montage simple du boîtier 1 sur le circuit imprimé 4 bien adapté au soudage à la vague des composants d'un circuit imprimé.

Le cambrage des parois 13 permet la tenue de la vis par frottement sur les parois élastiques en position haute pendant les manipulations de la carte.

## Revendications

1. Procédé pour rendre imperdable une vis de fixation (3) d'un circuit imprimé (4) sur un support (5) caractérisé en ce qu'il consiste à immobiliser la vis entre les parois élastiques (2) d'un boîtier (1) par pincement de la vis entre les parois après avoir percé le fond (8) du boîtier (1) d'un trou (9) pour permettre le serrage de la vis (3) par un outil de serrage, à engager l'extrémité de la vis opposée à sa tête dans un trou de fixation du circuit imprimé (4) sur son support (5), et à fixer les extrémités des parois opposées au fond du boîtier sur le circuit imprimé autour du trou de fixation du circuit imprimé (4).

2. Dispositif pour rendre imperdable une vis de fixation (3) d'un circuit imprimé (4) sur un support (5) caractérisé en ce qu'il comprend un boîtier (1) dont la largeur intérieure entre ses parois latérales est inférieure au plus grand diamètre de la vis (3) pour permettre lorsque la vis est engagée dans le boîtier le maintien par pincement de la vis (3) à l'intérieur du boîtier (1).

3. Dispositif selon la revendication 2 caractérisé en ce que le boîtier (1) comporte un fond (8) percé d'un trou (9) d'un diamètre inférieur au plus grand diamètre de la vis (3) afin d'empêcher le passage de celle-ci dans le trou (9) traversant le fond (8).

4. Dispositif selon la revendication 3 caractérisé en ce que les parois du boîtier (1) sont munies de fentes pour procurer l'élasticité nécessaire au pincement de la vis (3) entre les parois.

5. Dispositif selon la revendication 3 caractérisé en ce que les parois du boîtier (1) comportent des fenêtres.

6. Dispositif selon l'une quelconque des revendications 1 à 5 caractérisé en ce que la hauteur du boîtier (1) est égale à la hauteur totale de la vis (3) diminuée de l'épaisseur du circuit imprimé (4).

7. Dispositif selon l'une quelconque des revendications 1 à 6 caractérisé en ce que le boîtier possède des pattes (6) de fixation sur le circuit imprimé.

8. Dispositif selon l'une quelconque des revendications 1 à 7 caractérisé en ce que le boîtier possède une languette (11) rabattable pour former le boîtier.

9. Dispositif selon l'une quelconque des revendications 1 à 8 caractérisé en ce que le boîtier possède au moins une paroi plus longue (13) engageable dans un trou du circuit imprimé pour permettre une fixation simple par soudage à la vague du circuit imprimé.
